# EUROPEAN PATENT APPLICATION

(11) **EP 3 988 689 A1**
(43) Date of publication of application: **27.04.2022**
(21) Application number: 20203418.7
(22) Date of filing: 22.10.2020
(51) Int. Cl.: C30B 29/04, C30B 33/12

(54) **METHOD OF ETCHING CRYSTALLINE MATERIAL**

(71) Applicant: Evince Technology Limited, Newcastle Upon Tyne, Tyne and Wear NE6 5AL (GB)
(72) Inventor: TAYLOR, Gareth Andrew, Newcastle upon Tyne Tyne & Wear, NE6 5AL (GB); FARRAR, Paul, Chilton, County Durham, DL17 0EQ (GB); DOUGLAS, Robert, Andrew, Bishop Auckland, County Durham, DL14 0JF (GB)
(74) Representative: Vinsome, Rex Martin

(57) **Abstract**

A method of etching crystalline diamond is disclosed. The method comprises depositing a catalytic metal (20) on a body of crystalline diamond (4), and causing the catalytic metal to react with the diamond to provide a metal carbide. A gas mixture (26) is reacted with carbon from the metal carbide to provide a gaseous material which includes carbon, and a eutectic regulating gas is provided for increasing the rate of provision of the carbon-containing gaseous material.

## Description

The present disclosure relates to a method of etching crystalline material, and relates particularly, but not exclusively, to a method of catalytically etching diamond material.

Catalytic etching of diamond is of considerable interest for a variety of applications. For example, it has long been recognized that diamond's extreme properties make it a very attractive material for electronic applications. In particular, the wide bandgap, high carrier mobility and excellent thermal conductivity mean that it could excel in semiconductor applications requiring high frequency and power. Recent advances in synthesis technology mean that it is now possible to manufacture diamond of sufficiently high quality that its use in electronic applications can at last be seriously considered. Catalytic etching has been shown to be important as an alternative technique to etch diamond from more conventional techniques, such as those that utilise low-pressure gas plasmas, which is broadly chemically inert except to highly reactive species such as atomic or ionised oxygen. However, such processes can be difficult to control, particularly where highly anisotropic features are required. The use of a metal catalyst presents the opportunity to restrict and control the diamond etching process to specific locations and directions. In particular this is the first step to create high aspect ratio hole features that can be metallised to create high efficiency field emission structures embedded within a diamond substrate employed in diode, triode and electron source devices amongst other applications that this technique enables.

Diamond's high mechanical hardness, low thermal expansion coefficient and chemical inertness also make it ideal for biosensor applications where minimal interaction with the target medium is highly desirable in order to prevent rejection or unwanted reactions. Consequently, catalytic etching can also be used to create biosensor structures such as nanopore filters used for the molecular analysis of DNA.

It is also of interest to structure the surface of a diamond film, substrate or particle in a selective and/or controlled manner using catalytic etching. The initial surface of the diamond, or a desired portion thereof, can be coated with a thin film of metal catalyst that enables that portion of the surface to be modified according to the particular application. The nature of the resulting surface modification will be dependent on a combination of factors including, but not limited to: the thickness of the applied metal catalyst; the crystal orientation; the reagent gas chemistry; and, the temperature of processing. Such an approach has widespread applications, for example, to control tribology, to promote adhesion in a biosensor, or to control the properties and adhesion of films which are subsequently deposited on the diamond. Another application would be to use a catalyst modified surface to better understand the growth mechanisms in play during CVD growth of diamond.

This document refers to diamond throughout and by default includes single-crystal, polycrystalline, nanocrystalline and ultra-nanocrystalline diamond films, except where explicitly stated otherwise. Each of these diamond types will display the diamond structure within grains but over widely varying length scales. Consequently grain boundary effects, crystal orientation and other factors will influence the electrical and other properties of these films. These are summarised for example in the review article Nanocrystalline diamond, Diamond & Related Materials 20 (2011) 621-640*.*

US 7,781,257 discloses the use of a metal catalyst such as nickel, cobalt or iron among a family of metals known to carbide with diamond patterned on a diamond substrate, which when heated in a suitable reducing atmosphere, etches diamond. This occurs through the mechanism of (1) reaction of the catalyst with the diamond to convert SP3 carbon from the diamond to SP2 carbon, (2) reaction of the SP2 carbon with the catalyst to form an unstable carbide, (3) diffusion of the carbon through the catalyst to the other face of the catalyst exposed to reducing atmosphere, and (4) reaction of the free carbon with the gas present to remove carbon from the catalyst, thus tending to prevent saturation of the catalyst and sustaining the reaction in step (1) above.

However, this known process suffers from the drawback that the process can saturate if the gas phase reaction (4) is not sufficiently rapid to remove the solute carbon (3) within the catalyst, causing the etch process to cease. Further, the process described results in features dictated by the orientation of the starting crystal plane, for example catalyst anisotropic etching of the {100} surface resulting in an inverted pyramidal structure whose walls are defined by the {111} plane. While this has potential uses, it would be far more desirable to create more complex etch features for many other applications where starting crystal orientation or saturation is not a limiting factor; for example, the creation of deep high aspect ratio structures having complex and controlled cross-sectional profiles, optimised for specific applications including but limited to: the enablement of high efficiency field emission into a diamond substrate for solid-state electron devices; and channel structures for micro-fluidic or optical light path applications.

Preferred embodiments of the present disclosure seek to overcome one or more of the above disadvantages of the prior art.

According to an aspect of the disclosure, there is provided a method of etching crystalline material, the method comprising:
depositing a first material on a body of a second material, wherein the first material is a catalytic material and the second material is a crystalline material containing a first chemical species;
causing the first material to react with the second material to provide a third material, wherein the third material includes said first chemical species;
causing a fourth material to react with said first chemical species from said third material to provide a fifth material, wherein the fifth material is a gaseous material and includes said first chemical species; and
providing a sixth material for increasing a rate of provision of said fifth material.

By providing a sixth material for increasing a rate of provision of the fifth material, this provides the advantage of minimising saturation of the etching reaction.

The sixth material may be adapted to regulate a eutectic state of said third material at least at a surface of said third material.

By providing a material for regulating a eutectic state of the third material at least at a surface of the third material, this provides the advantage of maintaining the mobility of the first material so that it remains in contact with the preferred reaction face of the second material.

The sixth material may be adapted to impede fragmentation of said first material.

By providing a material adapted to impede fragmentation of the first material, this provides the advantage of enabling uniformity of cross-section of recesses generated in the second material by the etching process to be maintained.

The sixth material may comprise ammonia.

The fourth material may include a seventh material adapted to react with the third material to release said first chemical species from said third material, and an eighth material adapted to react with the released first chemical species. By providing a seventh material adapted to react with the third material to release said first chemical species from said third material, and an eighth material adapted to react with the released first chemical species, this provides the advantage of enhancing the generation of the fifth material, thereby further minimising saturation of the etching process.

The seventh material may include an oxidising agent.

The seventh material may include oxygen.

The eighth material may include a reducing agent.

The eighth material may include hydrogen.

The method may further comprise providing a ninth material adapted to inhibit fragmentation of said first material.

By providing a ninth material adapted to reduce fragmentation of said the material, this provides the advantage of enabling uniformity of cross-section of recesses generated in the second material by the etching process to be maintained.

The ninth material may be deposited on said second material with said first material.

The method may further comprise providing a tenth material adapted to inhibit the reaction of said first material with said second material.

By providing a tenth material adapted to inhibit the reaction of said first material with said second material, this provides the advantage of enabling control of the direction of etching to be improved.

The second material may be a group IV material.

The second material may be diamond and the third material may be a carbide.

The method may further comprise controlling the temperature of the body of second material.

The temperature of the body of second material may be controlled to maintain a temperature of a chemical reaction between the first and second materials within predetermined limits.

The first material may be deposited by means of vapour deposition.

The step of depositing the first material on the body of second material may be carried out by means of at least one lithographic step.

The method may further comprise applying a force to at least part of said first material to enhance penetration of said second material by said first material.

The force may be applied electrostatically and/or magnetically.

According to another aspect of the disclosure, there is provided a method of etching crystalline material, the method comprising:
depositing a first material on a body of a second material, wherein the first material is a catalytic material and the second material is a crystalline material containing a first chemical species;
causing the first material to react with the second material to provide a third material, wherein the third material includes said first chemical species;
causing a fourth material to react with said first chemical species from said third material to provide a fifth material, wherein the fifth material is a gaseous material and includes said first chemical species; and
providing a sixth material for inhibiting fragmentation of said first material.

By providing a sixth material adapted to reduce fragmentation of said the material, this provides the advantage of enabling uniformity of cross-section of recesses generated in the second material by the etching process to be maintained.

The sixth material may be deposited on said second material with said first material.

The sixth material may comprise copper.

The method may further comprise providing a seventh material for increasing a rate of provision of said fifth material.

The seventh material may be adapted to regulate a eutectic state of said third material at least at a surface of said third material.

The seventh material may be adapted to impede fragmentation of said first material.

The seventh material may comprise ammonia.

The fourth material may include an eighth material adapted to react with the third material to release said first chemical species from said third material, and a ninth material adapted to react with the released first chemical species.

The eighth material may include an oxidising agent.

The eighth material may include oxygen.

The ninth material may include a reducing agent.

The ninth material may include hydrogen.

The method may further comprise providing a tenth material adapted to inhibit the reaction of said first material with said second material.

The second material may be a group IV material.

The second material may be diamond and the third material may be a carbide.

The method may further comprise controlling the temperature of the body of second material.

The temperature of the body of second material may be controlled to maintain a temperature of a chemical reaction between the first and second materials within predetermined limits.

The first material may be deposited by means of vapour deposition.

The step of depositing the first material on the body of second material may be carried out by means of at least one lithographic step.

The method may further comprise applying a force to at least part of said first material to enhance penetration of said second material by said first material.

The force may be applied electrostatically and/or magnetically.

According to a further aspect of the disclosure, there is provided a method of etching a crystalline material, the method comprising:
depositing at least one catalytic material on a body of crystalline material;
causing the catalytic material to react with said crystalline material at a first temperature, wherein said catalytic material preferentially etches said crystalline material in a first direction; and
causing said catalytic material to react with said crystalline material at a second temperature, different from said first temperature, such that said catalytic material preferentially etches said crystalline material in a second direction, different from said first direction.

By causing the catalytic material to react with the crystalline material at a plurality of temperatures such that the catalytic material preferentially etches the crystalline material in different directions, this provides the advantage of enabling the profile of holes and/or recesses in the crystalline material to be more carefully controlled. This in turn provides the advantage of enabling field emission electronic devices of better performance to be made.

The crystalline material may be diamond.

The catalytic material may include at least one metal capable of forming an unstable compound comprising reactive material and the target etch material at elevated temperatures.

The method may further comprise applying a force to at least part of at least one said catalytic material to enhance penetration of said crystalline material by said catalytic material.

The force may be applied electrostatically and/or magnetically.

Preferred embodiments of the present disclosure will now be described, by way of example only and not in any limitative sense, with reference to the accompanying drawings in which:
Figure 1 is a schematic view of an apparatus for carrying out a process embodying the present disclosure;
Figure 2A is a view of part of the apparatus of Figure 1 for applying an electric field to the metal catalyst and diamond substrate using a direct method of substrate heating;
Figure 2B is an alternative configuration of the apparatus of Figure 1 for applying an electric field to the metal catalyst and diamond substrate using an indirect method of substrate heating;
Figure 3 schematically illustrates the catalytic etching process carried out by the apparatus of Figure 1;
Figure 3A schematically illustrates the catalytic etching process carried out by the apparatus of Figure 1 with the addition of a material adapted to inhibit the reaction of the catalyst with the diamond; Figure 3B schematically illustrates further details of the etching process of Figure 3;
Figure 4A is a photographic plan representation of a first etch feature carried out by the apparatus of Figure 1;
Figure 4B is a schematic cross-sectional view of the etch feature of Figure 4a;
Figure 5A is a photographic cross-sectional representation of a second etch feature carried out by the apparatus of Figure 1;
Figure 5B is a schematic cross-sectional view of the etch feature of Figure 5A;
Figure 6A is a photographic cross-sectional representation of a third etch feature carried out by the apparatus of Figure 1;
Figure 6B is a schematic cross-sectional view of the etch feature of Figure 6A;
Figure 7 is a profile of temperature against time used in an etching process carried out by the apparatus of Figure 1;
Figure 8A is an example of the results of etching of nanocrystalline diamond by the apparatus of Figure 1;
Figure 8B is a detailed view of part of Figure 8A;
Figure 9 shows a schematic view of a radiation detector formed using the apparatus of Figure 1;
Figure 10 shows of an electron emission device formed using the apparatus of Figure 1; and
Figure 11 shows a schematic view of an arrangement having via-type structures formed using the apparatus of Figure 1.

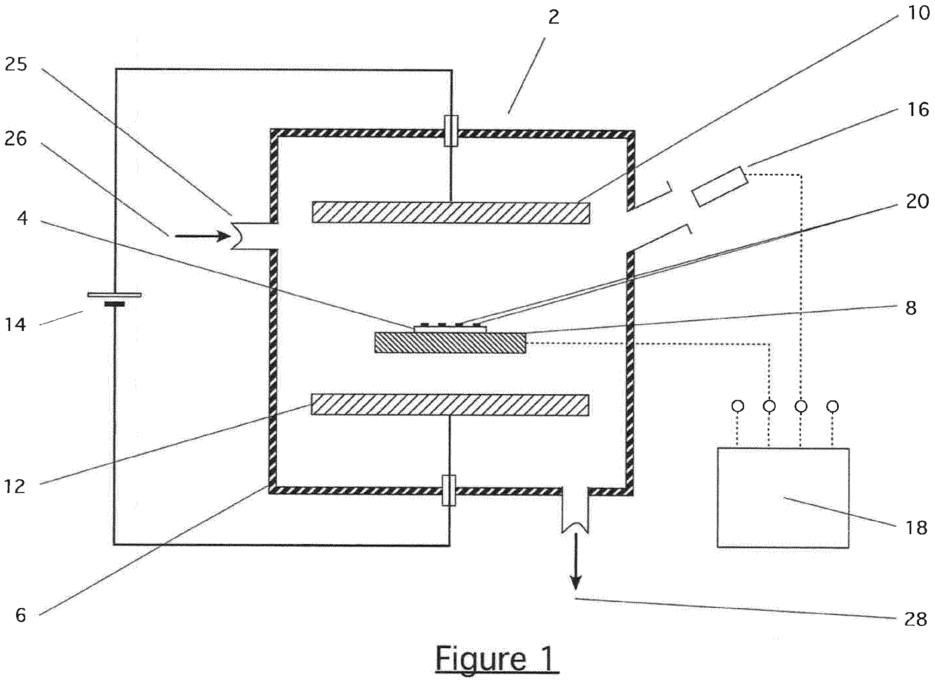

Referring to Figure 1, an apparatus 2 for carrying out a process embodying the present disclosure for forming holes and/or recesses in a diamond substrate 4 for forming field emission based electronic devices is described. The apparatus 2 has a low-pressure process chamber 6 in which the diamond substrate 4 is arranged on a substrate heater 8 between an upper field electrode 10 and a lower field electrode 12. The latter may also be defined by a common point of electrical reference with the substrate heater 8. The electrodes 10, 12 are connected to a DC power supply 14 to enable an electric field to be applied to the diamond substrate 4. The temperature of the diamond substrate 4 is determined by means of a tungsten hot filament optical pyrometer 16, and signals from the pyrometer 16 are used by a controller 18 to control the substrate heater 8 to control the temperature of the diamond substrate 4.

Those skilled in the art will appreciate that different methods of determining temperature are available which can generate measured values at variance with those using the stated method and such understanding of the cause of these variances will enable them to apply a suitable correction factor.

A first material in the form of a catalytic metal 20 such as nickel is deposited on a second material in the form of the diamond substrate 4, containing a first chemical species in the form of carbon, to a thickness between 30nm and 500nm with a more typical range of 120nm to 250nm of by means of physical vapour or chemical metal deposition and lithographic techniques which will be familiar to persons skilled in the art. In the case of high aspect ratio etching the choice of thickness will determine the eventual diameter of etch feature which is approximately the diameter of a spheroid ball of catalyst metal whose diameter in turn is derived as a direct correlation with the volume of the deposited film. The diamond substrate 4 is a {100} oriented single crystal diamond substrate 4, but the principle could be applied to etch structures into other crystal orientations such as the {110} orientation.

The chamber 6 is filled with a fourth material in the form of a gas mixture 26 containing an eighth material in the form of a reducing agent such as hydrogen, a sixth material for increasing the rate of provision of a fifth material, further details of which are provided below, such as a eutectic regulating agent such as ammonia, and a trace amount of a seventh material in the form of an oxidising agent such as oxygen. Other oxidants such as water vapour may also be used. In order to prevent combustion of the diamond substrate 4, the oxidant level is kept less than 2% of the overall gas concentration. The bulk process gas is a reducing agent such as hydrogen with the two other gases making up typically <15% portion of the overall gas mix. A typical ratio of the stated gases is 95 H₂ : 5 NH₃ : 0.5 O₂. However, those skilled in the art may modulate this ratio in accordance with the conditions imparted by their own equipment and the desired etch profile. Typical ratios of the wetting gas to the oxidant gas will be in the range of 40: land 1:1 respectively and more typically in the range of 15:1 and 3:1. The process is undertaken at a low pressure in the range of 1 torr to 30 torr, with a more typical range between 3 torr and 10 torr. The gas mixture 26 is delivered to the chamber via an inlet 25, and waste gas is removed via an outlet 28.

The substrate 4 is heated to a temperature between in the range of 800 degrees C and 1250 degrees C as measured by a hot filament pyrometer 16 - the choice of temperatures being determined by the crystallographic nature of the substrate 4, the choice of catalyst 20 and the type of etch feature required.

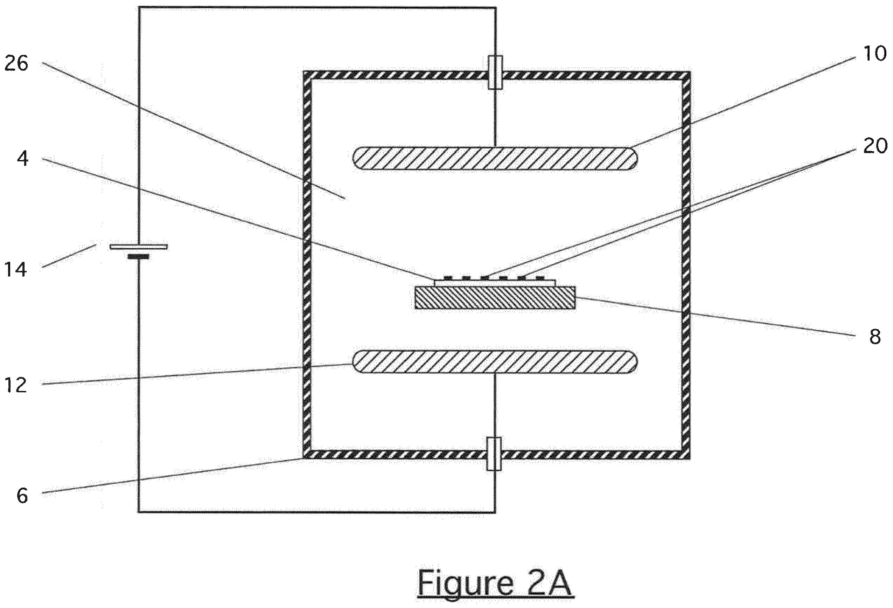

Figure 2A shows part of the apparatus of Figure 1 for applying an electric field to the metal catalyst 20 and diamond substrate 4 using a direct method of substrate heating such as a proximate heater element made from a material capable of remaining inert to the process gases such as silicon carbide.

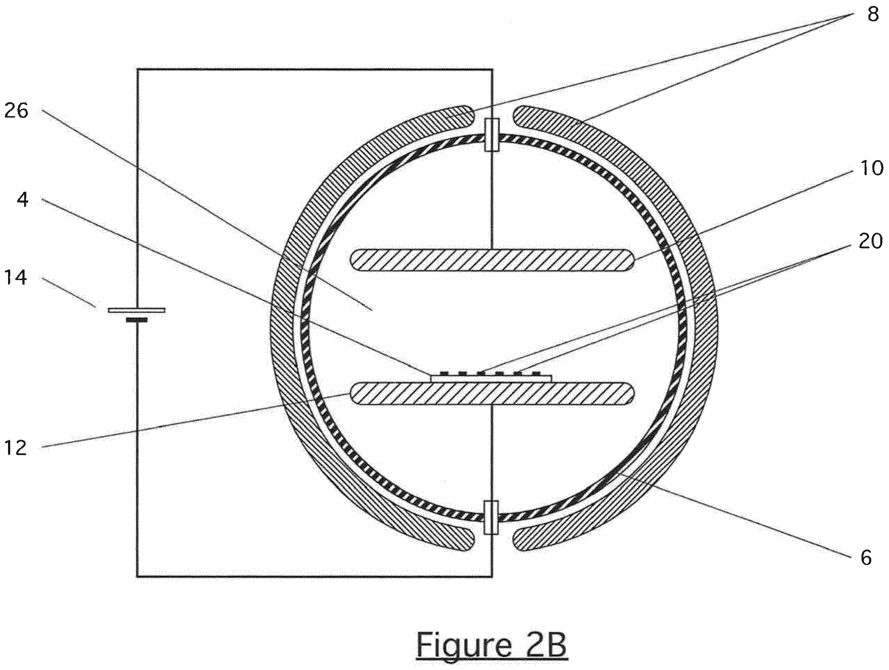

Figure 2B shows part of the apparatus of Figure 1 for applying an electric field to the metal catalyst 20 and diamond substrate 4 using an indirect method of substrate heating such as a tube furnace or infra-red-light source, whereby the DC field is maintained through an electrode arrangement within the area containing the process gases.

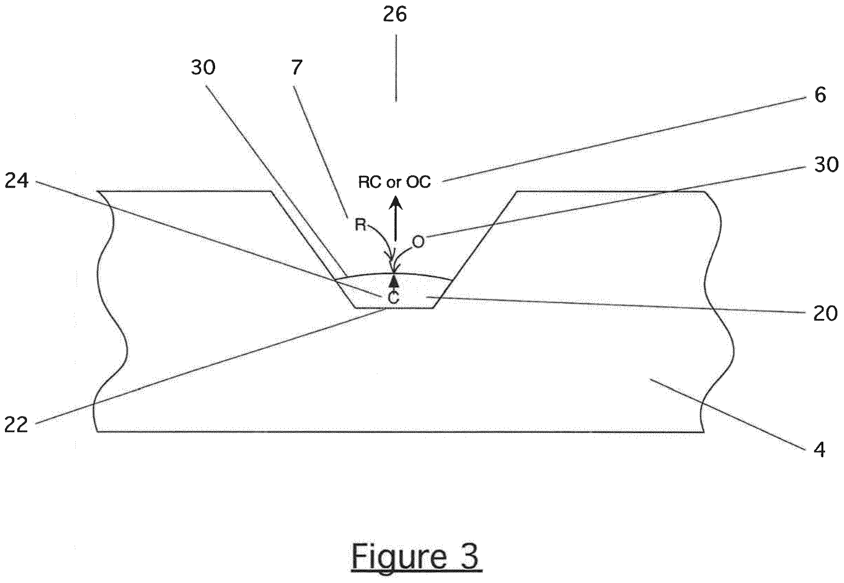

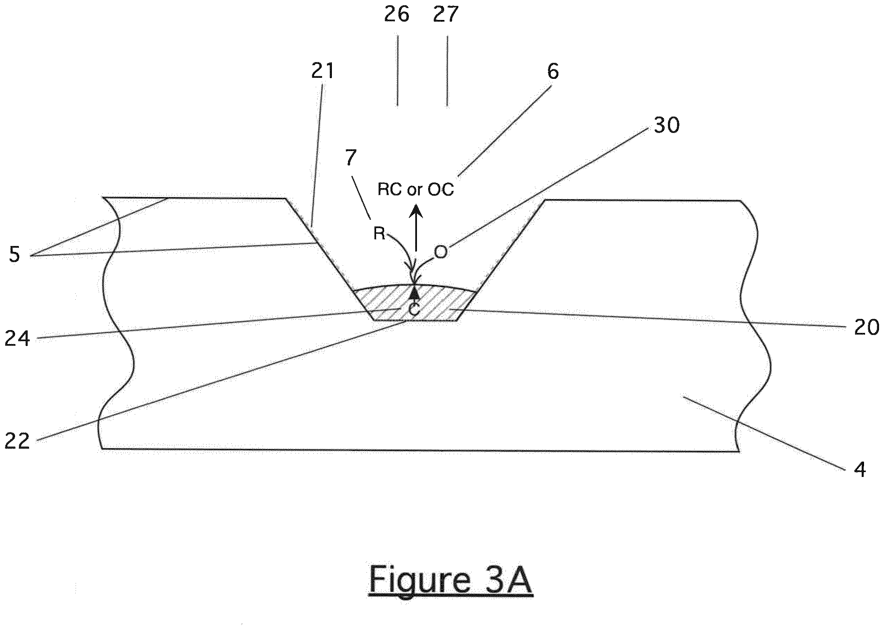

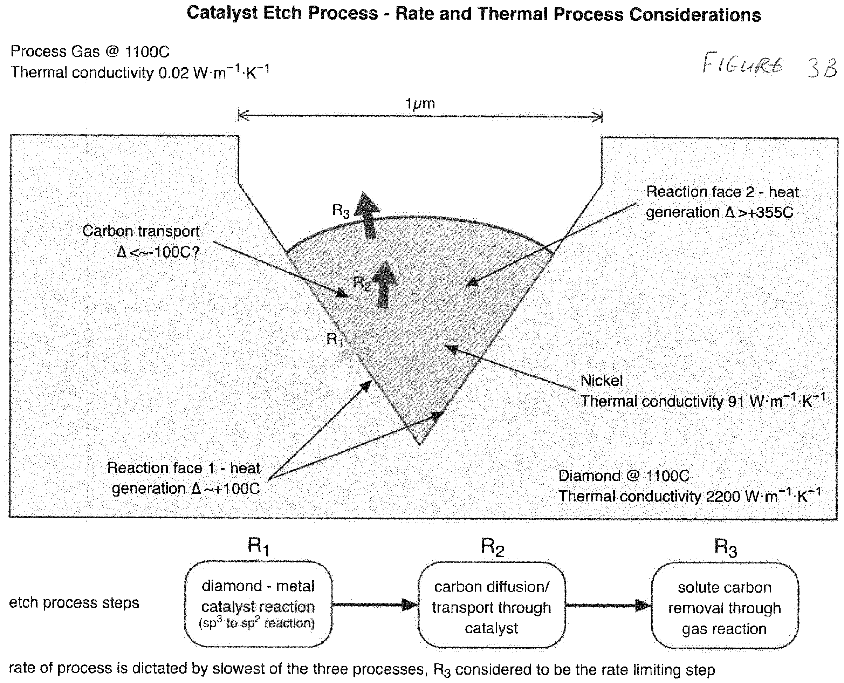

Referring to Figure 3, the catalytic process is described in more detail. At elevated temperatures the catalytic metal 20 reacts with the diamond substrate 4 at metal-diamond interface 22 to convert SP3 carbon of the diamond substrate 4 to non-diamond carbon 24 in the form of amorphous SP2 carbon. The SP2 carbon then reacts with the catalytic metal 20 to form a third material in the form of an unstable metal carbide eutectic. This reaction is exothermic, as is also the subsequent removal mechanism described below, which is more exothermic. The thermal conductivity ratios of the process gas 26, the catalyst 20 and the diamond 4 are of the order of 1: 4500: 110,000. The exothermic reactions at interface 22 coupled with the heat generated at the interface 30 therefore create a thermal gradient whereby the local temperature of the catalyst particles 20 is in excess of the actual applied temperature thereby allowing the catalyst 20 to exist in a semi-liquidus state. The carbon of the unstable metal carbide is therefore able to diffuse through the body of the catalytic metal 20 to an interface 30 where the catalytic metal 20 is exposed to the gas mixture 26, consisting predominantly of the reducing atmosphere of hydrogen with the eutectic regulating gas ammonia and the trace oxidising agent such as oxygen whose proportions are determined by the desired form of etching. The catalyst carbide at the gas-catalyst interface 30 reacts with the process gases in one of two principal ways:
(i) by redox reaction with the catalyst metal 20 whereby the surface carbon is replaced by the oxidising agent to form a catalyst oxide thereby releasing the diffused carbon 24, only to subsequently react with one of the reducing components of the gas mixture at the gas-catalyst interface 30, while at the same time, the free carbon reacts with either a reducing agent or the oxidising agent from the gas mixture to remove carbon 24 from the catalyst surface 30 as a fifth material in the form of a compound molecule 6 of the process gas 26; or
(ii) by direct reaction of the carbon at the catalyst surface 30 with any of the available gas components 26 to form the fifth material in the form of a gaseous carbon compound 6.

Those skilled in the art will appreciate that the balance of these mechanisms will be dictated by the actual applied process conditions, in particular the specific ratios of the gaseous components used and the process temperature.

Both mechanisms allow further carbon 24 in the unstable catalyst metal carbide 20 to diffuse to the surface thereby sustaining the carbon generating reaction of the catalyst at the diamond interface 22. The resultant gaseous carbon compounds 6 can then be removed from the chamber 6 via the outlet 28, to enable the etching reaction to continue. The sixth material in the form of ammonia increases the rate of production of the fifth material by regulating a eutectic state of the instable carbide at least at a surface of the carbide. In addition, the six material inhibits fragmentation of the catalytic material by reducing the extent to which the catalytic material becomes encapsulated by carbon released from the carbide.

Further improvements to the basic process so far described can be made to improve the behaviour of the catalyst such that it continues to move as a whole in the desired direction and thereby improve the quality of resultant etched feature.

Those skilled in the art will recognise that it may be desirable to adjust the material properties of the catalyst to improve the liquidus state of the resultant eutectic to minimise fragmentation of the catalyst and so that the catalyst is better able to remain in contact with the desired reaction face(s). The addition of a ninth material in the form of additional material 21 (Figure 3A) that is not chemically active but capable of alloying with the catalyst 20, such as copper, in concentrations of less than 10% and ideally less than 5% with respect to the catalyst can provide a means of lowering the viscosity of the catalyst in the liquidus state, whilst also acting as a binding agent and reducing the incidence of catalyst break-up which can result in surface roughening or non-linearity of the resultant etch due to multiple simultaneous instances of the etch process occurring in a localised area, instead of the catalyst acting as a uniform whole. This material 21 can be incorporated by depositing a thin layer of the material on the metal catalyst 20 using the already described techniques for this - ideally in such a manner so that the material 21 is sandwiched by, or codeposited with a layer of the catalyst 20.

Referring to Figure 3A, once the catalyst has reacted with the intended area of the diamond and moved to the next area of reaction, it can be desirable to reduce the possibility of further catalytic reaction by passivating the surface 5 of the diamond 4 that is not in direct contact with the metal catalyst. The addition of a tenth material in the form of a redox agent 27 of sufficiently large molecular size so as not to diffuse into the catalyst, for example, sulphur dioxide to the mix of reactive gases 26 at concentrations equal to or less than the main oxidising component, that may marginally improve the etch rate, but will also react with the exposed diamond to create a monolayer of sulphur and/or sulphur oxide 21 that is chemically bonded to the diamond surface 5 that serves to inhibit further catalyst reaction 22 with exposed diamond. In so doing the surface roughness of the etch can be greatly reduced, which in turn aids downstream processes such as metallisation and surface functionalisation.

Figure 3B shows the reaction process of Figure 3 in greater detail for conversion of carbon of the diamond substrate 4 into carbon containing gas of the process gas 26. It can be seen that step R1 involves catalytic reaction of the catalyst 20 with carbon of the diamond substrate to convert the sp³ carbon of the diamond to sp² carbon of the metal carbide eutectic. Step R2 involves diffusion of carbon through the catalytic carbide eutectic to the surface of the eutectic, where it comes into contact with the gas mixture 26. Step R3 involves reaction of the carbon to form a carbon-containing molecule of the gas mixture 26. Steps R1, R2 and R3 in effect occur in series, as a result of which the diamond etching process is impeded by the slowest of R1, R2 and R, which is considered to be R3 in the present case. The addition of the sixth material accelerates the process of R3, thereby increasing the rate of etching if the diamond overall.

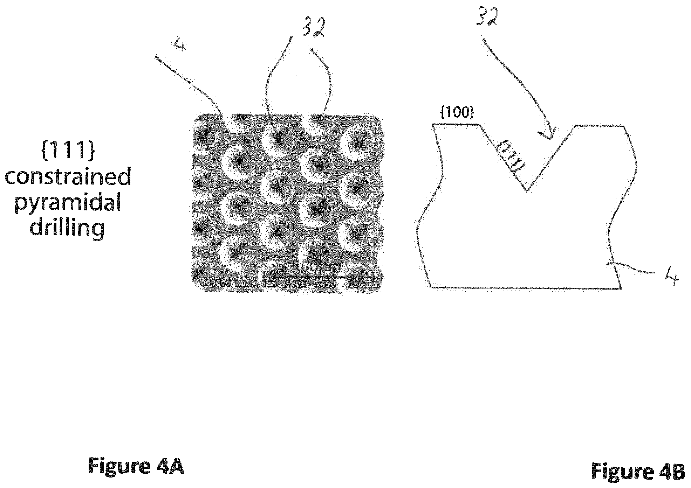

Referring to Figures 4 to 6, examples of the effect of adjustment of the reaction of the catalyst 20 and the diamond 4 by control of the temperature at which the reaction takes place in the case of single crystal diamond are described. In each of these cases the catalyst 20 has been deposited using a lithographic process that enables defined regions of the diamond 4 to be subject to the reaction processes. Figures 4 to 6 show etch processes constrained by two important crystallographic orientations, the {111} and {110} direction. However, it will be appreciated by persons skilled in the art that etch processes for other constraint planes, for example a preference mode for the {110} plane for other temperatures, could be envisaged.

Referring to Figures 4A and 4B, an example is shown of recesses 32 formed in the diamond substrate 4 in the form of an etch pattern whereby a {100} orientated single crystal diamond substrate 4 is patterned with a 250nm thickness layer 20 (Figures 1 and 2) of nickel deposited on the substrate using standard vapour or chemical metal deposition and lithographic techniques. The substrate 4 is then heated to a temperature in the region of 1020°C to 1040°C (measured using a tungsten hot filament optical pyrometer 16, although it will be appreciated by persons skilled in the art that other temperature measurement methods may yield slightly different temperature readings) in the atmosphere previously stated, resulting in the catalyst 20 preferentially reacting with the {100} crystal plane and being constrained by the {111} crystal plane, resulting in an pyramidal shaped etch feature. The {111} acts as a stop plane in this case because the orientation of the atomic bonds makes the surface more stable against the dissolution of carbon into the catalyst. The etch rate in the preferred plane is of the order 1-3µm per hour at this temperature, while reaction with the {111} constraining face can be tuned by correct selection of temperature so that the etch rate is >100 times less. The temperature at which the metal catalyst 20 reacts with the substrate 4 is consistent regardless of the applied temperature. The catalyst can be removed through immersion of the substrate in a suitable etchant such as Aqua Regia in the case of Nickel.

Other catalyst metals will yield differing etch temperatures. For example, cobalt will react similarly in the range of 900° C to 915° C. Rate will also be affected by the ambient pressure of the system. Generally the higher the pressure, the faster the rate, but the poorer the morphology of the resulting features.

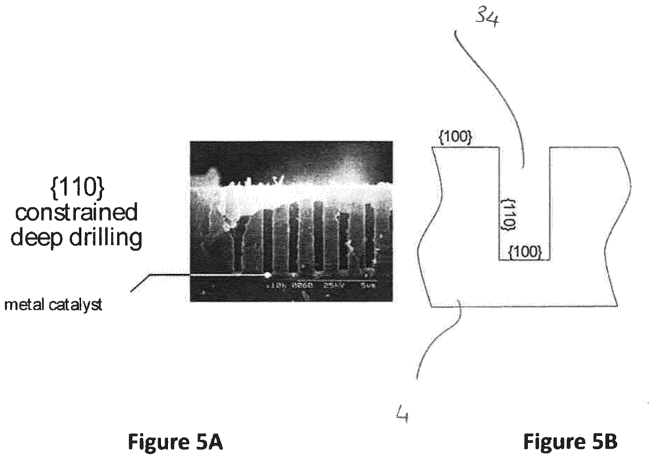

Figures 5A and 5B show a further example of an etch pattern whereby a {100} orientated single crystal diamond substrate 4 is patterned with a 250nm thickness layer 20 of nickel deposited on the substrate 4 using standard vapour or chemical metal deposition and lithographic techniques. The substrate 4 is then heated to a temperature of between 1160°C and 1200°C (again measured using the tungsten hot filament optical pyrometer 16, although other temperature measurement methods may yield slightly different temperature readings) in the reducing/oxidizing atmosphere and in the presence of an electric field where the applied voltage is below the threshold needed to strike a plasma discharge, causing the catalyst 20 to preferentially react with the {100} surface. However, this time the reaction is constrained by the {110} crystal plane. The reaction of the catalyst 20 occurs at a comparable rate to the case of Figures 4A and 4B (around 3µm per hour)and forms a deep channel 34. It has been shown that considerably higher etch rates of 10-15µm/h can also be achieved by tuning the process. Other catalyst metals such as cobalt, iron, and platinum will trigger a similar reaction at different temperatures. However, the principle will remain that high aspect structure ratio will occur at higher temperatures than the pyramidal etch.

Referring to Figure 2, in order to ensure that the catalyst reacts with the correct orientation, a DC electric field is also applied by means of the power supply 14 and electrodes 10, 12, in addition to the application of heat. This applies an electrostatic force on the catalyst particle 20, which due to the feature size of the catalyst particles 20 will tend to be positively charged due to loss of electrons from field emission caused by a combined effect of the process temperature involved and the applied field, as a result of which the catalyst 20 will be attracted to the cathode 12. In the present case, the applied bias is such that a field of between 150Vcm⁻¹ and 300Vcm⁻¹ is created i.e. below the threshold required to cause a gas discharge to form. However, refinements to this approach could also be achieved by applying a DC biased high frequency supply sufficient to strike a discharge in the gas, whereby the net DC component is the same as that described above. This discharge being predominantly hydrogen could serve to further accelerate the etch process and provide a gentle plasma etch to remove any asperities caused by the catalyst etch. Alternatively, or in addition, a suitable dipole magnetic field can be applied, either alone or in combination with the applied electric field, although since the temperature of the reaction exceeds the curie point a significantly higher magnetic field would need to be applied.

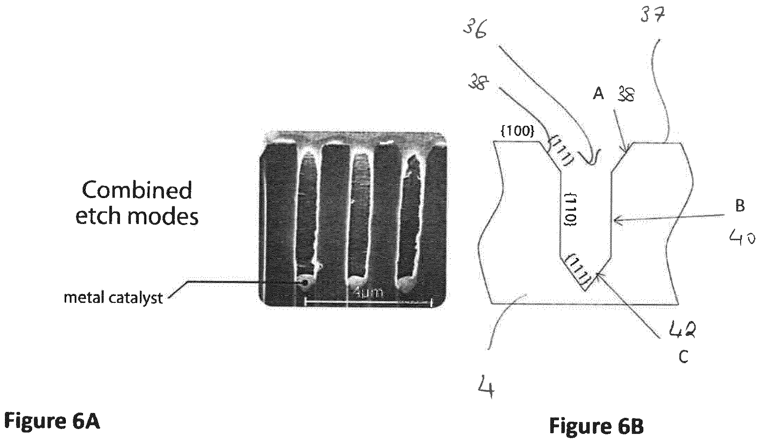

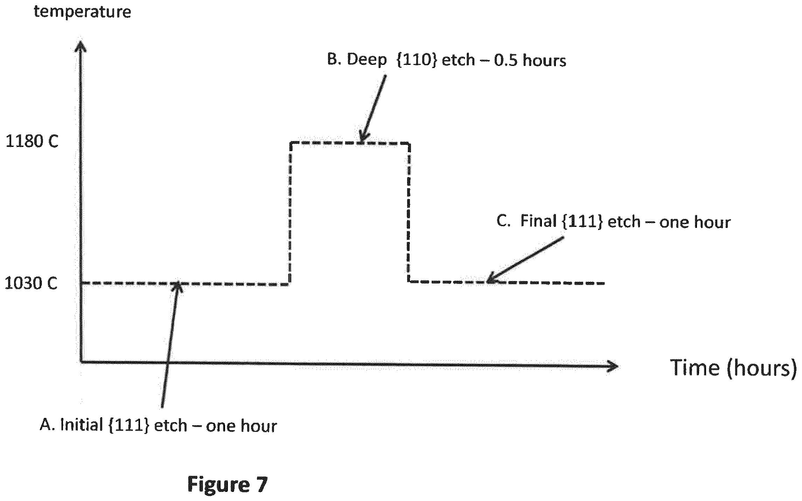

Referring to Figures 6A, 6B and 7, structures incorporating two or more crystallographic planes can be created because of the difference in temperatures at which the catalyst 20 preferentially reacts with the crystal planes of the diamond substrate 4. A deep etch 36 suitable for a diamond-based field emission device incorporating {111} and {110} planes is illustrated in Figures 6A and 6B, and a typical etch process temperature profile used to create it is illustrated in Figure 7. The structure is fabricated based on an initial isotropic etch of the {100} plane 37, constrained by the {111} plane 38, at a temperature of around 1030°C for one hour, corresponding to part A of Figure 7. The temperature is then raised to 1180° C for a period of 30 mins (section B of Figure 7), in the presence of a DC biased electric field, leading to an increased etch rate of around 3 µm/hour to create a deep etch feature 40 constrained by {110} planes. Finally a pyramidal tip 42 is created by another {111} etch at a reduced temperature of 1030° C for a further 30 to 60 minutes (section C of Figure 7). For those skilled in the art the process could be applied in alternative ways such as in a cyclic sequence, oscillating between two or more conditions to improve control over the catalyst particle and resultant etch morphology.

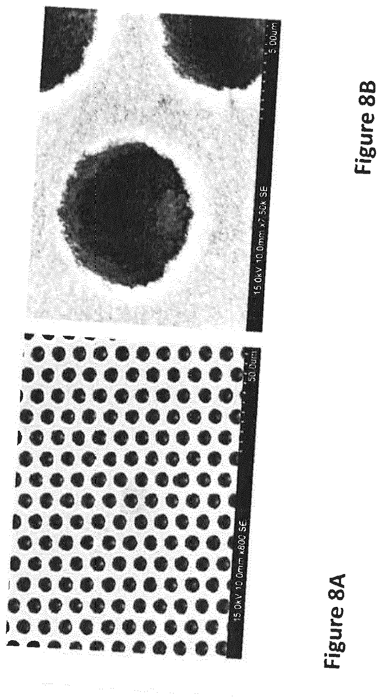

The process described above can also be used modify the surface of other forms of diamond so as to effect surface modification for a variety of purposes. One example of this is etching of nanocrystalline diamond for membranes, filters or MEMs, as illustrated in Figure 8. In this example, a 3µm thickness nanocrystalline diamond film is grown on a silicon substrate using CVD or hot filament techniques, and the diamond layer is patterned with a 250nm thick layer of nickel deposited on the substrate using standard vapour or chemical metal deposition and lithographic techniques. The substrate is then heated to a suitable temperature in a reducing/oxidizing gas mixture with an applied electrical field such that the catalyst will experience an electro-static force pulling the catalyst towards the cathode of the external field. The size of the etch feature will be determined by the combination of the catalyst size, process temperature and the thickness of the original applied layer. This makes it possible to etch large areas or features as small as a few nm diameter.

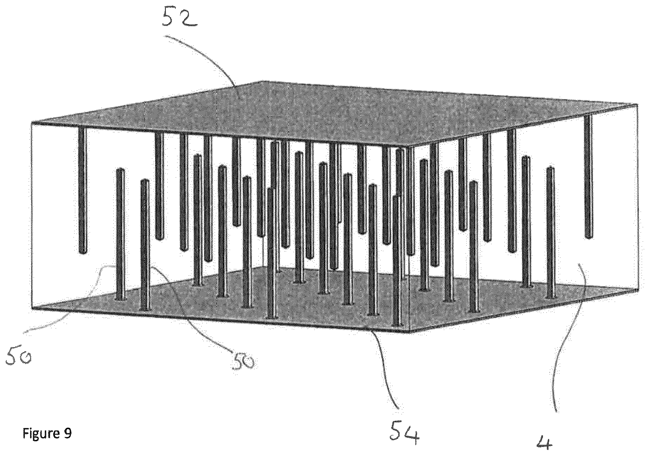

The creation of ordered structured features in diamond using catalyst etching has multiple applications. Figures 9 to 11 illustrate a number of such potential applications by way of example, and do not represent the total applications that those skilled in the art may further identify.

Referring to Figure 9, it is known that the sensitivity of diamond-based radiation detectors can be increased by increasing the surface area of the collector electrodes. The present method provides a way of etching vertical structures 50 into the diamond 4 that can increase the surface area of the anode 52 and cathode 54 collector by use of a structured etch process to enhance both electrodes 52, 54 yielding an interdigitated comb-like structure through the creation of multiple hole features using a single set of process steps, thus enabling rapid manufacture of such a structure. Those skilled in the art can enhance the benefits of the resultant features created by the catalyst etch process through optimal choice of metals and surface interface to effect low resistance ohmic contacts for both electrodes.

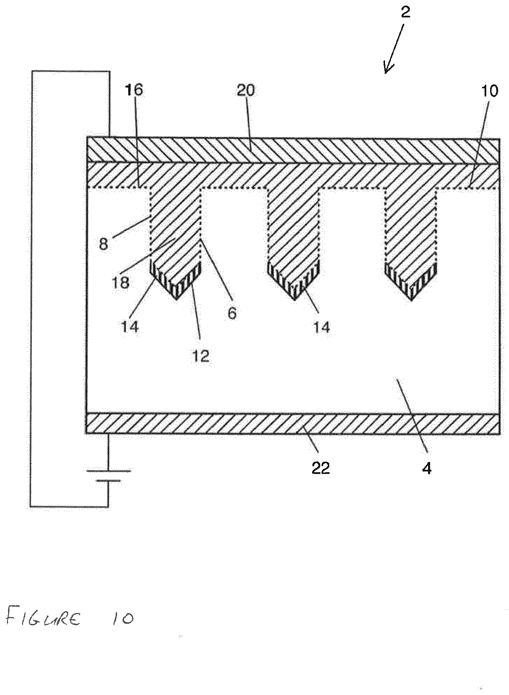

Referring to Figure 10, the catalyst etch process can be used to create hole features 6 in diamond 4 that form the basis of field emission structures 18 embedded within the diamond substrate 4. Those skilled in the art will appreciate that subsequent surface engineering and correct Schottky metallisation of the resultant holes 6 can yield structures 18 capable of high efficiency electron injection into the conduction band of diamond, thereby in-turn enabling a number of solid-state electron devices unique to diamond including: diodes; triodes (and those with a plurality of additional control gates); and, vacuum electron sources.

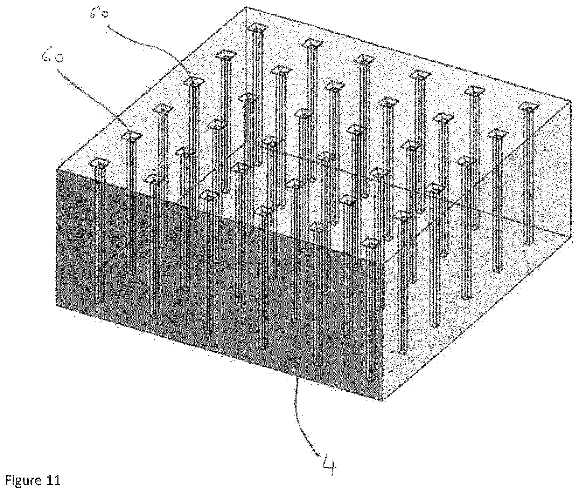

Referring to figure 11, the catalyst etch process can be used to make via type structures 60 through a diamond substrate 4, making it possible to create multi-layer devices as well as photonic and micro-fluidic type structures. In this case the diameter of the channels 60 would be determined by the starting volume of catalyst deposited and allowing the process to run for sufficient time for the catalyst to etch entirely through the diamond substrate 4.

It will be appreciated by persons skilled in the art that the above embodiments have been described by way of example only and not in any limitative sense, and that various alterations and modifications are possible without departure from the scope of the disclosure as defined by the appended claims. For example, although the process as described above is primarily applicable to diamond, by suitable selection of the metal catalyst and combination of the reducing oxidizing components of the reactive gases it will be possible to etch any other material, in particular those containing other group IV elements, whereby the base substrate material can be transported through the catalyst material when at processing temperature.

## Claims

1. A method of etching crystalline material, the method comprising:
depositing a first material on a body of a second material, wherein the first material is a catalytic material and the second material is a crystalline material containing a first chemical species;
causing the first material to react with the second material to provide a third material, wherein the third material includes said first chemical species;
causing a fourth material to react with said first chemical species from said third material to provide a fifth material, wherein the fifth material is a gaseous material and includes said first chemical species; and
providing a sixth material for increasing a rate of provision of said fifth material.

2. A method according to claim 1, including one or more of the following features:
(i) wherein said sixth material is adapted to regulate a
eutectic state of said third material at least at a surface of said third material;
(ii) wherein said sixth material is adapted to impede fragmentation of said first material;
(iii) wherein said sixth material comprises ammonia; or
(iv) wherein the fourth material includes a seventh material adapted to react with the third material to release said first chemical species from said third material, and an eighth material adapted to react with the released first chemical species.

3. A method according to claim 2, including one or more of the following features:
(i) wherein the seventh material includes an oxidising agent; or
(ii) wherein the eighth material includes a reducing agent.

4. A method according to claim 3, including one or more of the following features:
(i) wherein the seventh material includes oxygen; or
(ii) wherein the eighth material includes hydrogen.

5. A method according to any one of the preceding claims, including one or more of the following features:
(i) further comprising providing a ninth material adapted to inhibit fragmentation of said first material;
(ii) further comprising providing a tenth material adapted to inhibit the reaction of said first material with said second material;
(iii) wherein the second material is a group IV material;
(iv) further comprising controlling the temperature of the body of second material;
(v) wherein the step of depositing the first material on the body of second material is carried out by means of at least one lithographic step; or
(vi) further comprising applying a force to at least part of said first material to enhance penetration of said second material by said first material.

6. A method according to claim 5, including one or more of the following features:
(i) wherein said ninth material is deposited on said second material with said first material;
(ii) wherein the second material is diamond and the third material is a carbide;
(iii) wherein the temperature of the body of second material is controlled to maintain a temperature of a chemical reaction between the first and second materials within predetermined limits; or
(iv) wherein the force is applied electrostatically and/or magnetically.

7. A method of etching crystalline material, the method comprising:
depositing a first material on a body of a second material, wherein the first material is a catalytic material and the second material is a crystalline material containing a first chemical species;
causing the first material to react with the second material to provide a third material, wherein the third material includes said first chemical species;
causing a fourth material to react with said first chemical species from said third material to provide a fifth material, wherein the fifth material is a gaseous material and includes said first chemical species; and
providing a sixth material for inhibiting fragmentation of said first material.

8. A method according to claim 7, including one or more of the following features:
(i) wherein said sixth material is deposited on said second material with said first material;
(ii) wherein said sixth material comprises copper;
(iii) further comprising providing a seventh material for increasing a rate of provision of said fifth material;
(iv) wherein the fourth material includes an eighth material adapted to react with the third material to release said first chemical species from said third material, and a ninth material adapted to react with the released first chemical species;
(v) further comprising providing a tenth material adapted to inhibit the reaction of said first material with said second material;
(vi) wherein the second material is a group IV material;
(vii) further comprising controlling the temperature of the body of second material;
(viii) wherein the step of depositing the first material on the body of second material is carried out by means of at least one lithographic step; or
(ix) further comprising applying a force to at least part of said first material to enhance penetration of said second material by said first material.

9. A method according to claim 8, including one or more of the following features:
(i) wherein said seventh material is adapted to regulate a
eutectic state of said third material at least at a surface of said third material;
(ii) wherein said seventh material is adapted to impede fragmentation of said first material;
(iii) wherein said seventh material comprises ammonia;
(iv) wherein the eighth material includes an oxidising agent;
(v) wherein the ninth material includes a reducing agent;
(vi) wherein the second material is diamond and the third material is a carbide;
(vii) wherein the temperature of the body of second material is controlled to maintain a temperature of a chemical reaction between the first and second materials within predetermined limits; or
(viii) wherein the force is applied electrostatically and/or magnetically.

10. A method according to claim 9, including one or more of the following features:
(i) wherein the eighth material includes oxygen; or
(ii) wherein the ninth material includes hydrogen.

11. A method of etching a crystalline material, the method comprising:
depositing at least one catalytic material on a body of crystalline material;
causing the catalytic material to react with said crystalline material at a first temperature, wherein said catalytic material preferentially etches said crystalline material in a first direction; and
causing said catalytic material to react with said crystalline material at a second temperature, different from said first temperature, such that said catalytic material preferentially etches said crystalline material in a second direction, different from said first direction.

12. A method according to claim 11, wherein the crystalline material is diamond.

13. A method according to claim 11 or 12, wherein the catalytic material is at least one metal capable of forming an unstable compound comprising of reactive material and the target etch material at elevated temperatures.

14. A method according to any one of claims 11 to 13, further comprising applying a force to at least part of said catalytic material to enhance penetration of said crystalline material by said catalytic material.

15. A method according to claim 14, wherein the force is applied electrostatically and/or magnetically.
